# EUROPÄISCHE PATENTANMELDUNG

(11) **EP 0 675 521 A2**
(43) Veröffentlichungstag der Anmeldung: **04.10.1995**
(21) Anmeldenummer: 95103687.0
(22) Anmeldetag: 14.03.1995
(51) Int. Cl.: H01J 61/30, H01J 61/82, H01J 61/35, H01L 21/027

(54) **Quecksilberhochdrucklampe**

(30) Priorität: 29.03.1994 DE 4410968
(71) Anmelder: Patent-Treuhand-Gesellschaft für elektrische Glühlampen mbH, D-81543 München (DE)
(72) Erfinder: Dierks, Jörn, D-10367 Berlin (DE); Maier, Jürgen, Dr., D-13503 Berlin (DE)

(57) **Zusammenfassung**

Die vorzugsweise bei 365 nm emittierende Lampe besitzt einen Kolben aus Quarzglas, das mit bis zu 250 ppm Vanadium (als Oxid) dotiert ist, um die kurzwellige UV-Strahlung zu absorbieren.

## Beschreibung

Die Erfindung geht aus von einer Quecksilberhochdrucklampe gemäß dem Oberbegriff des Anspruchs 1.

Derartige Lampen werden bevorzugt für die Belichtung von Fotolacken bei der Herstellung von Halbleitern eingesetzt.

Bevorzugt wird dabei mit der Quecksilberlinie bei 365 nm gearbeitet (I-Linie), evtl. auch mit der bei 436 nm gelegenen Linie. Einzelheiten des Belichtungsverfahrens und der dabei verwendeten Lampe finden sich in der DE-OS 35 27 855, auf die hiermit ausdrücklich bezug genommen wird.

Ein grundsätzliches Problem derartiger Lampen ist die unerwünschte Strahlung bei Wellenlängen unterhalb der Nutzwellenlänge, die das Gesamtsystem belasten und daher nach Möglichkeit unterdrückt werden sollen. Der Weg, der üblicherweise dafür eingeschlagen wird, ist das Einbringen eines Absorptionsfilters in den Strahlengang, siehe hierzu wieder DE-OS 35 27 855. Es handelt sich dabei um ein Interferenzfilter oder Farbfilter. Nachteilig an ersterer Lösung ist das Auftreten von Absorptionslücken durch Nebenmaxima des Schichtstapels, während bei der zweiten Lösung Intensitätsverluste in Kauf genommen werden müssen.
Im Zuge der Weiterentwicklung der Belichtungstechnik und der zunehmenden Verwendung leistungsstärkerer Lampen (typisch bis zu 5 kW oder mehr) haben sich die auftretenden Probleme, die durch diese unerwünschte kurzwellige Strahlung hervorgerufen werden, zunehmend verschärft. Neben der größeren thermischen Belastung durch Strahlungsabsorption und den größeren durch die UV-Strahlung hervorgerufenen Strahlungsschäden (Solarisation) im Beleuchtungssystem hat sich insbesondere die Ozonproduktion der Lampen als problematisch erwiesen. Diese setzt chemische Reaktionen in Gang, die zu Belägen auf den optischen Komponenten des Belichtungssystems führen können. Des weiteren treten auch andere UV-induzierte Reaktionen auf, die auf UV-Strahlung des gesamten Wellenlängenbereiches unterhalb 365 nm beruhen.

Es ist Aufgabe der vorliegenden Erfindung, eine gattungsgemäße Lampe bereitzustellen, deren Nutzwellenlängen möglichst ohne Dämpfung zur Verfügung stehen, während die unerwünschte Strahlung bei Wellenlängen unterhalb der Nutzwellenlängen möglichst effektiv unterdrückt werden soll.

Diese Aufgabe wird durch die kennzeichnenden Merkmale des Anspruches 1 gelöst. Bevorzugte Ausgestaltungen finden sich in den abhängigen Ansprüchen.

Das spezifische Problem der vorliegenden Erfindung liegt darin, daß nutzbare Emissionslinien (≧ 365 nm) und unerwünschte Emissionslinien unterhalb 365 nm sehr eng beieinander liegen, so daß bekannte Maßnahmen nicht ausreichen.

Bei Glühlampen ist die Verwendung von Dotierstoffen für das Kolbenglas (aus Vycor oder Hartglas) zur Unterdrückung des UV-Anteils bekannt. Doch handelt es sich hier um Kontinuumstrahlung geringer Intensität, die zu kurzen Wellenlängen hin stark abnimmt. Aus der DE-OS 14 96 072 ist eine Glühlampe bekannt, bei der Vanadium, Cer oder Molybdän als dotierendes Metallion verwendet werden in einer Menge von 300 - 3000 ppm-Gew. Dabei ist eine Glaskolbenstärke von 1 mm angesetzt. Das Einsatzgebiet dieser Dotierung ist der Bereich unter 300 nm. Diese Dotierungen haben sich überraschenderweise deswegen als ungeeignet für das vorliegende Problem erwiesen, weil sie die Nutzwellenlänge von 365 nm bereits merklich dämpfen. Eine weitere vorbekannte Maßnahme ist die Verwendung einer Ti0₂-Beschichtung (US-PS 4 985 275). Dieses Material absorbiert jedoch wesentlich erst unterhalb von ca. 240 nm und ist daher wegen des großen Abstandes zur Nutzwellenlänge allenfalls als Zusatz geeignet.

Erfindungsgemäß wird ein Kolben aus Quarzglas verwendet, dem eine geringe Menge Vanadium (als Oxid) zugesetzt wird. Dabei hat sich eine Menge von 250 ppm (Gew.) als ausreichend erwiesen, bezogen auf 1 mm Wandstärke. Bei größeren Wandstärken kann der Dotiergehalt entsprechend (in etwa linear) reduziert werden.

Größere Dotiermengen würden die Nutzwellenlänge bei 365 nm dämpfen und außerdem eine unerwünschte Absorption im sichtbaren Strahlungsbereich bewirken.

Eine bevorzugte Obergrenze ist 200 ppm. Insbesondere bei Kleiner Lampenleistung sind oft schon weniger als 150 ppm ausreichend. Als praktische Untergrenze für die Wirksamkeit der Absorption hat sich ein Wert von 20 ppm erwiesen. Generell ist bei höherer Lampenleistung eine höhere Dotierung zu wählen.

Zusätzlich kann das Absorptionsverhalten bei sehr kurzen Wellenlängen (unterhalb ca. 300 bzw. 250 nm) durch Zugabe der Oxide von Zinn bzw. von Titan in einer Gesamtmenge bis zu 500 ppm (Gew.), bezogen auf 1 mm Wandstärke, verbessert werden. Insbesondere können auch beide Materialien gleichzeitig verwendet werden.

Alternativ kann auch zumindest eines dieser Materialien als Beschichtung auf die Kolbenwand aufgetragen werden.

Bevorzugte Wandstärken des Kolbens liegen bei 1 bis 5 mm, insbesondere 1,5 bis 4,0 mm.

Um eine hohe Intensität der Nutzwellenlängen zu erzielen, enthält die Füllung vorzugsweise 0,5 bis 15 mg/cm³ Quecksilber. Außerdem hat sich als Startgas Xenon mit einem Kaltfülldruck, der zwischen 0,1 und 3,0 bar, bevorzugt unter 2,0 bar liegt, bewährt. Der Elektrodenabstand liegt bei dieser Speziallampe zwischen 2 und 9 mm.

Die Betriebstemperatur, gemessen an der Außenwand des Kolbens, erreicht Werte zwischen 400 und 950^{o}C. Sie muß deshalb berücksichtigt werden, weil bekanntlich die genaue Lage der Absorptionskante des Vanadiums davon abhängt. Die Verwendung von Vanadium in geringer Menge ist auch bei anderen Entladungslampentypen möglich, bei denen nur ein Teil der UV-Emission genutzt werden soll.

Die Erfindung wird im folgenden anhand zweier Ausführungsbeispiele näher erläutert. Es zeigt
- Figur 1: eine erfindungsgemäße Quecksilberhochdrücklampe
- Figur 2: ein Spektrum einer derartigen Lampe.

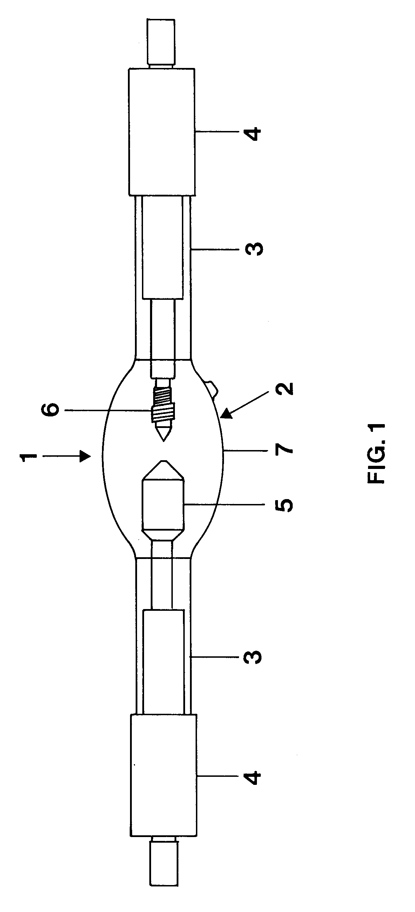

In Figur 1 ist schematisch eine Quecksilberhochdrücklampe 1 mit einem Entladungsgefäß 2, zwei Schaftabschnitten 3 und jeweils daran befestigten Sockeln 4 gezeigt. Die Lampe wird mit einer Leistung von 1000 W unter Gleichstrom betrieben. Die Anode 5 und die Kathode 6 stehen sich in einem Abstand von 3 mm gegenüber. Das Entladungsgefäß 2 ist aus Quarzglas mit einer Wandstärke von ca. 2,8 mm gefertigt, das mit Vanadiumoxid dotiert ist. Der Vanadiumanteil liegt bei etwa 35 ppm. Zusätzlich ist der Kolben mit Ti0₂ beschichtet; die Dicke der Schicht 7 beträgt 1 µm. Der Kolben ist mit 8 mg/cm³ Quecksilber und Xenon mit einem Kaltfülldrück von 1,7 bar gefüllt. Die Betriebstemperatur des Kolbens erreicht außen Werte bis zu 750^{o}C.

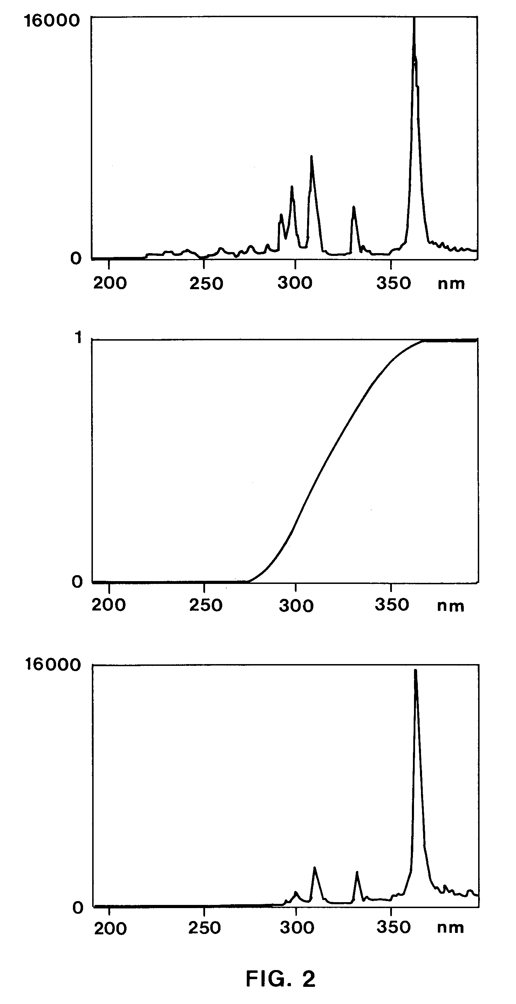

Einen Ausschnitt aus dem Lampenspektrum zwischen 200 und 400 nm zeigt Figur 2. Oben ist ein Lampenspektrum ohne Dotierung des Quarzglases gezeigt. In der Mitte ist das Absorptionsverhalten der erfindungsgemäßen Dotierung dargestellt. Unten ist das verbesserte Lampenspektrum (mit Dotierung) gezeigt.

Man erkennt, daß die Nutzwellenlänge bei 365 nm tatsächlich ungeschwächt ist, während die unerwünschte Liniengruppe um 300 nm stark gedämpft ist. Sie kann ggf. durch Zusatz von Sn0₂ noch stärker unterdrückt werden.

Ein weiteres Ausführungsbeispiel ist eine 3300 W-Lampe mit einer Hg-Füllung von 3 mg/cm³ und einem Xenon-Kaltfülldrück von 0,8 bar. Der Elektrodenabstand beträgt 6,5 mm. Der Kolben ist bei einer Wandstärke von 3,7 mm mit Vanadium (50 ppm) und Titan (40 ppm) in Form ihrer Oxide dotiert.

Diese erfindungsgemäßen Lampen gestatten eine erhebliche Reduktion der Kosten des Gesamtsystems, da nicht nur externe Sperrfilter für den UV-Bereich vereinfacht oder ganz weggelassen werden können, sondern sich auch der Systemwirkungsgrad, dessen Durchsatz und auch Lebensdauer erhöht. Ein positiver Nebeneffekt ist, daß die vermehrte Absorption im kurzwelligen UV den Kolben aufheizt. Dieser Effekt kann umgekehrt dazu benutzt werden, das Lampenvolumen zu vergrößern, ohne daß die Gefahr der Hg-Kondensation auftritt. Dadurch wird die Gefahr der Kolbenschwärzung vermindert.

## Patentansprüche

1. Quecksilberhochdrücklampe mit einem Entladungsgefäß aus Quarzglas, das zwei Elektroden und eine Füllung enthält, die Quecksilber und Xenon umfaßt, dadurch gekennzeichnet, daß die Füllung darauf abgestimmt ist, im Bereich von Nutzwellenlängen, die durch Quecksilber erzeugt werden und zumindest die Resonanzlinie bei ca. 365 nm umfassen, zu emittieren, wobei gleichzeitig zur Absorption von Wellenlängen unterhalb von 365 nm das Quarzglas, bezogen auf 1 mm Wandstärke, Vanadium als Metallion eines Dotierstoffes in einer Menge von weniger als 250 ppm (Gew.) enthält, und wobei die äußere Wandtemperatur des Entladungsgefäßes zwischen 400 und 950^{o}C beträgt.

2. Quecksilberhochdrücklampe nach Anspruch 1, dadurch gekennzeichnet, daß der Vanadiumanteil kleiner als 200 ppm ist.

3. Quecksilberhochdrücklampe nach Anspruch 2, dadurch gekennzeichnet, daß der Vanadiumanteil zwischen 20 und 150 ppm liegt.

4. Quecksilberhochdrücklampe nach einem der vorhergehenden Ansprüche, dadurch gekennzeichnet, daß das Quarzglas zusätzlich Titan und/oder Zinn als Metallion eines Dotierstoffs in einer Gesamtmenge bis zu 500 ppm (Gew.) enthält.

5. Quecksilberhochdrücklampe nach einem der vorhergehenden Ansprüche, dadurch gekennzeichnet, daß das Quarzglas mit Ti0₂ oder Sn0₂ beschichtet ist.

6. Quecksilberhochdrücklampe nach einem der vorhergehenden Ansprüche, dadurch gekennzeichnet, daß die Wandstärke des Entladungsgefäßes zwischen 1 und 5 mm beträgt.

7. Quecksilberhochdrücklampe nach einem der vorhergehenden Ansprüche, dadurch gekennzeichnet, daß die Füllung Quecksilber in einer Menge zwischen 0,5 und 15 mg/cm³ sowie Xenon mit einem Kaltfülldrück von 0,1 bis 2,5 bar umfaßt.

8. Quecksilberhochdrucklampe nach Anspruch 1, dadurch gekennzeichnet, daß der Elektrodenabstand zwischen 2 und 9 mm beträgt

9. Verwendung einer Lampe gemäß einer der vorhergehenden Ansprüche für die Belichtung von Fotolacken bei der Herstellung von Halbleitern.
